**Europäisches Patentamt**

**European Patent Office**

**Office européen des brevets**

(19)

(11) Veröffentlichungsnummer: **0 136 968**
**B1**

## EUROPÄISCHE PATENTSCHRIFT

(12)

(45) Veröffentlichungstag der Patentschrift:
**18.01.89**

(21) Anmeldenummer: **84730103.3**

(22) Anmeldetag: **27.09.84**

(51) Int. Cl.⁴: **H 03 K 17/64**, H 01 F 7/18

(54) Schaltungsanordnung zur Speisung eines Elektromagneten mit einem Anzugsstrom und einem nachfolgenden Haltestrom.

(30) Priorität: **30.09.83 US 537705**

(43) Veröffentlichungstag der Anmeldung:
**10.04.85 Patentblatt 85/15**

(45) Bekanntmachung des Hinweises auf die Patenterteilung:
**18.01.89 Patentblatt 89/3**

(84) Benannte Vertragsstaaten:
**DE FR GB IT**

(56) Entgegenhaltungen:
**DE-A- 3 112 280**
**DE-A- 3 112 621**
**DE-A- 3 208 660**
**DE-A- 3 240 114**

**BAUTEILE REPORT, 15. Jahrgang, Heft 1 Januar 1977, Berlin und München, O. SCHMID "Siemens-Metall-(Zink-)-Oxid-Varistor SIOV" Selten 24-27**

(73) Patentinhaber: **Siemens Aktiengesellschaft Berlin und München, Wittelsbacherplatz 2, D-8000 München 2 (DE)**

(72) Erfinder: **Culligan, John Louis, 843 Minden Avenue, Kenner Louisiana 70062 (US)**
Erfinder: **Stich, Frederick Alan, 2665 N. Lake Drive, Milwaukee Wisconsin 53211 (US)**
Erfinder: **Williams, Conrad Filmore, 7328 Alabama Street, New Orleans Louisiana 70126 (US)**

## Beschreibung

### Technisches Gebiet

Die Erfindung betrifft eine Schaltungsanordnung zur Speisung der Wicklung eines Elektromagneten mit einem Anzugsstrom und einem nachfolgenden Haltestrom, wobei der Speisestromkreis der Wicklung einen steuerbaren elektronischen Schalter mit einer Steuerelektrode enthält, der durch eine Steuereinrichtung periodische Steuerimpulse von veränderbarer Dauer und/oder Frequenz zuführbar sind.

### Zugrundeliegender Stand der Technik

Eine Schaltungsanordnung dieser Art ist beispielsweise durch die DE-A-32 08 660 bekannt geworden. Die Steuerimpulse bewirken hierbei eine periodische Freigabe und Sperrung des elektronischen Schalters mit der Folge, dass die Betriebsspannung an die Wicklung im Takt der Steuerimpulse angelegt und abgeschaltet wird. Nach Massgabe der elektrischen Eigenschaften des Stromkreises der Wicklung fliesst in dieser ein schwankender Strom, der jeweils zu Beginn eines Steuerimpulses anzusteigen beginnt und bei Beendigung des Steuerimpulses wieder abfällt. Auf diese Weise lässt sich im wesentlichen verlustlos der unterschiedliche Leistungsbedarf der Wicklung beim Anziehen des Magneten und im folgenden Haltezustand bereitstellen. Im Gegensatz hierzu ist bei konventionellen sogenannten Sparschaltungen, bei denen zur Einstellung des verhältnismässig geringen Haltestromes ein Vorwiderstand in Reihe mit der Wicklung geschaltet wird, mit einem beträchtlichen Energieverlust zu rechnen. Darüberhinaus können die in Abhängigkeit von der mechanischen Bewegung des Elektromagneten betätigten, Hilfsschalter Anlass zu Störungen geben, die man benötigt, um den Vorwiderstand wirksam bzw. unwirksam zu machen.

Der Betrieb eines Elektromagneten durch periodisches Ein- und Ausschalten bietet die einfache Möglichkeit, einen minimalen Haltestrom bequem einzustellen. Dennoch lässt sich dieser Vorteil in der Praxis keineswegs völlig ausnutzen, weil mit einer Schwankung der Versorgungsspannung zu rechnen ist. Es muss daher dafür gesorgt sein, dass der Elektromagnet auch bei der niedrigsten vorkommenden Versorgungsspannung noch die erforderliche Anzugskraft und Haltekraft entwickelt, während bei der höchsten vorkommenden Versorgungsspannung eine Überlastung der Wicklung des Elektromagneten vermieden werden muss. Der Erfindung liegt in diesem Zusammenhang die Aufgabe zugrunde, auch bei schwankender Versorgungsspannung des Elektromagneten einen zuverlässigen Betrieb bei möglichst wirtschaftlicher Dimensionierung zu erreichen.

### Offenbarung der Erfindung

Diese Aufgabe wird gemäss der Erfindung dadurch gelöst, dass der Speisestromkreis einen Stromsensor enthält und dass die Ausgangsgrösse des Stromsensors mittels eines Einstellgliedes der Steuereinrichtung zuführbar ist. Auf diese Weise wird die Schaltungsanordnung von der Höhe der Versorgungsspannung weitgehend unabhängig, so dass die charakteristischen Werte für den Betrieb des Elektromagneten, nämlich der Anzugsstrom und der Haltestrom, stets eingehalten werden können. Der Elektromagnet kann infolgedessen allein nach Massgabe dieser charakteristischen Werte dimensioniert werden.

Nach einer Weiterbildung der Erfindung kann der vorgesehene Stromsensor zusätzlich als Sicherheitsorgan dienen, indem die Ausgangsgrösse des Stromsensors einer auf einen Grenzwert ansprechenden Abschalteinrichtung zuführbar ist, welche bei Überschreitung des Grenzwertes die Unterdrückung der Steuerimpulse für den ersten elektronischen Schalter veranlasst.

Bei einer vorteilhaften Ausgestaltung der Schaltungsanordnung nach der Erfindung kann die Steuereinrichtung einen mit konstanter Frequenz arbeitenden Oszillator zur Erzeugung einer Dreieckspannung und eine Referenzsignalstufe sowie zur Auswertung der Dreiecksspannung und eines Referenzsignals eine Vergleichsschaltung enthalten, die periodische Rechteckimpulse variabler Dauer als Steuerimpulse für den ersten elektronischen Schalter erzeugt. Ist das Referenzsignal niedrig im Vergleich zum Scheitelwert der Dreieckspannung, so erscheinen an der Vergleichsschaltung Signale mit einem annähernd der Breite der Basis der Dreieckspannung entsprechenden zeitlichen Abstand. Nähert sich dagegen das Referenzsignal dem Scheitelwert der Dreieckspannung, so wird der Signalabstand kürzer. Aus diesen Signalen sind auf einfache Weise Rechteckimpulse variabler Dauer zur Steuerung des ersten elektronischen Schalters zu gewinnen.

Der Anzugsstrom eines Elektromagneten braucht nur solange zu fliessen, bis der Anker seine Endstellung erreicht hat. Bei bekannten sogenannten Sparschaltungen ist daher ein Hilfsschalter vorgesehen, der die Endstellung des Ankers mechanisch erfasst und dann die Umschaltung des Elektromagneten auf den niedrigen Haltestrom veranlasst. Anstelle eines solchen Hilfsschalters können auch andere charakteristische Vorgänge im Betrieb des Elektromagneten zum Zweck der Umschaltung ausgenutzt werden, z.B. das sich verändernde Magnetfeld der Wicklung während des Anzugsvorganges oder bei der Anwendung des Elektromagneten als Antriebsvorrichtung eines Schaltgerätes Spannung oder Strom an der Hauptstrombahn des Schaltgerätes. Im Rahmen der Erfindung kann jedoch die Umschaltung auf den Haltestrom durch eine auf die Referenzsignalstufe wirkende Verzögerungsschaltung erfolgen, wobei weder ein Sensor noch ein Hilfsschalter benötigt werden. Die Verzögerungszeit lässt sich so einstellen, dass bei dem vorgesehenen Anwendungsfall des Elektromagneten ein sicheres Anziehen gewährleistet ist. Die Voraussetzung hierfür besteht insbesondere bei elektromagnetisch betätigten Schaltgeräten, bei denen der Bewegungswiderstand als gleichbleibend anzusehen ist.

Es wurde bereits erwähnt, dass die Steuereinrichtung unter Verwendung eines mit konstanter
Frequenz arbeitenden Oszillators aufgebaut werden kann. Stattdessen kann aber auch ein freilaufender spannungsgesteuerter Oszillator, d.h. ein
Oszillator mit veränderlicher Frequenz, verwendet werden, wobei ein Zeitkreis zur Anlegung einer zeitveränderlichen Spannung an den Oszillator vorgesehen ist, um Steuerimpulse entsprechend einem Anzugsstrom und einem Haltestrom
zu gewinnen.

Es ist bereits bekannt, parallel zu der Wicklung
eines mit Stromimpulsen betriebenen Elektromagneten einen weiteren elektronischen Schalter zu
legen, der in Verbindung mit einer Freilaufdiode
einen steuerbaren Freilaufkreis für den Wicklungsstrom bildet. Nach einer Weiterbildung der
Erfindung kann dieser Freilaufkreis einen weiteren Stromsensor enthalten, dessen Ausgangsgrösse gleichfalls der bereits erwähnten Abschalteinrichtung zuführbar ist.

Bei beabsichtigter Abschaltung um eine rasche
Entregung des Elektromagneten mit nur geringer
Überspannung zu erreichen, kann parallel zu der
Wicklung des Elektromagneten in Reihe mit einer
Freilaufdiode ein spannungsabhängiger Widerstand geschaltet sein.

Beschreibung der Zeichnungen

Die Erfindung wird im folgenden anhand der in
den Figuren dargestellten Ausführungsbeispiele
näher erläutert.

Die Figur 1 ist ein Funktionsschema zur Darstellung des Prinzips der Erfindung.

Die Figur 2 ist ein schematisches Schaltbild
einer Ausführungsform der Erfindung.

Die Figur 2a zeigt Kurvenformen, die in der
Schaltung gemäss der Figur 2 auftreten.

In der Figur 3 ist ein schematisches Schaltbild
einer weiteren Ausführungsform der Erfindung
dargestellt.

Beschreibung der bevorzugten Ausführungsformen

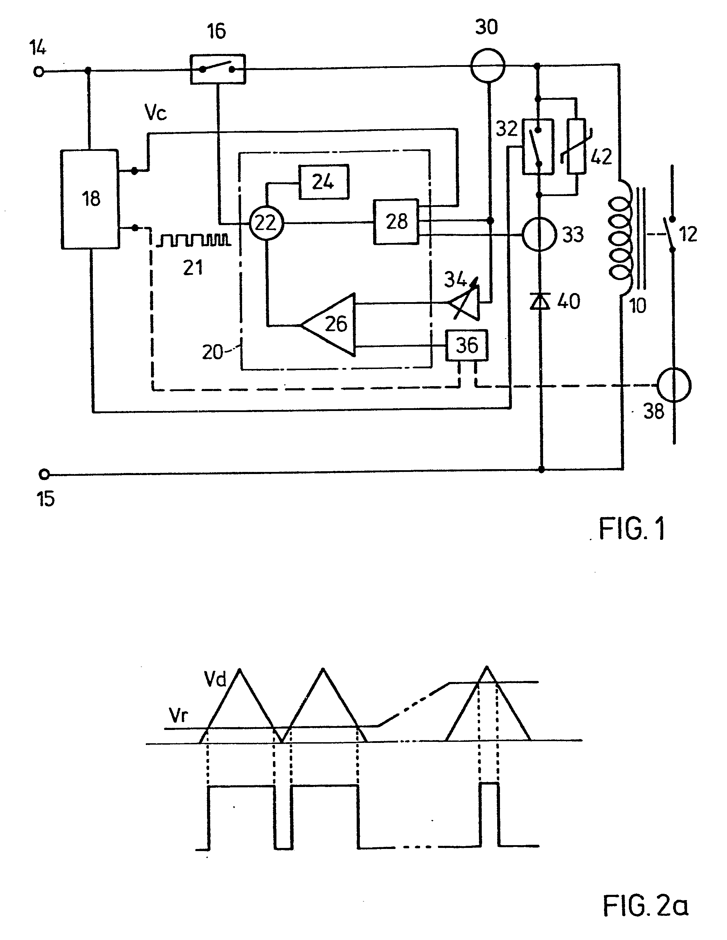

Die Figur 1 zeigt ein Schütz mit einer elektromagnetischen Betätigungswicklung 10 und Kontaktstücken 12. Wie ohne weiteres verständlich ist,
werden die Kontaktstücke in Abhängigkeit von
einem Magnetfluss der Wicklung 10 und eines
zugehörigen Kernes mittels geeigneter Verbindungsteile betätigt, zu denen ein Anker oder ähnliche Teile gehören können. Während in der Figur 1
im Ruhezustand geöffnete Kontaktstücke gezeigt
sind, sei darauf hingewiesen, dass es hierauf nicht
ankommt und ebensogut im Ruhezustand geschlossene Kontaktstücke vorgesehen sein können. Für die Zwecke der Erläuterung des vorliegenden Ausführungsbeispieles der Erfindung wird
jedoch angenommen, dass die Kontaktstücke im
Ruhezustand geöffnet sind und dass eine Erregung der Wicklung 12 zur Schliessung der Kontaktstücke führt. Die Erfindung und die folgende
Beschreibung sind jedoch gleichermassen auf
Schaltgeräte anwendbar, deren Kontaktstücke
durch Erregung der Wicklung geöffnet werden.

Es sind zwei Anschlussklemmen 14 und 15 zur
Verbindung mit einer Energiequelle (nicht gezeigt) vorgesehen, die als Gleichspannungsquelle
dargestellt ist. Ein erster Halbleiterschalter 16 ist
in Reihe mit der Energiequelle und der Wicklung
10 geschaltet, um einen Speisestromkreis der
Wicklung 10 zu schliessen oder zu öffnen. An die
Eingangsklemmen ist eine Stromversorgungseinrichtung 18 angeschlossen, die eine Betriebsspannungsquelle Vc für andere Elemente der
Schaltungsanordnung bildet. Eine in Figur 1 gestrichelt dargestellte und mit 20 bezeichnete Oszillatorschaltung ist mit dem ersten Schalter 16
verbunden und gibt eine Folge von mit 21 bezeichneten Steuerimpulsen zur Betätigung des ersten
Schalters ab.

An einem mit 22 bezeichneten Schaltungspunkt
werden periodische Signale eines Kurvengenerators 24 und einer Referenzsignalstufe 26 kombiniert, um die Kurve 21 zu bilden. Diese Ausgangsgrösse wird unter bestimmten Bedingungen durch
Signale einer Abschaltstufe 28 unterdrückt, die in
Abhängigkeit von dem Zustand der Stromversorgungseinrichtung 18 und von dem durch die Wicklung 10 fliessenden Strom arbeitet, der durch einen geeigneten Stromsensor 30 erfasst wird. Die
Abschaltstufe erhält ferner von einem weiteren
Stromsensor 33 ein Stromsignal aus einem parallel zu der Wicklung 10 geschalteten Freilaufkreis,
der einen zweiten elektronischen Schalter 32 enthält.

Die Referenzsignalstufe 26 gibt ein von dem
durch die Wicklung 10 fliessenden Strom abhängiges Ausgangssignal ab, wobei der Strom durch
den Sensor 30 erfasst und durch eine geeignete
Verstärkerstufe 34 einstellbar verstärkt wird. Die
Referenzsignalstufe 26 spricht auch auf ein zeitabhängiges Signal einer Verzögerungsstufe 36 an.
Bei einer bevorzugten Ausführungsform spricht
die Verzögerungsstufe 36 auf die Anlegung einer
Speiseenergie an ihrem Anschlusspunkt Vc an,
obwohl sie bei einer anderen Ausführungsform
auf den Zustand der Kontaktstücke 12 mittels eines geeigneten Stromsensors 38 anspricht.

Wird ein Strom durch eine Induktivität wie die
Wicklung 10 impulsförmig hindurchgeleitet (dieses Verfahren wird auch als Zeitverhältnissteuerung bezeichnet), so ist es erforderlich, einen
ständigen Stromkreis für die Wicklung aufrechtzuerhalten, und zu diesem Zweck ist eine sogenannte Freilaufdiode 40 zu der Wicklung 10 gegensinnig parallel geschaltet. Aus Gründen, die im folgenden ausführlicher erläutert werden, ist der
zweite Festkörperschalter 32 in Reihe mit der Diode 40 geschaltet, und ein nichtlinearer Widerstand 42, der ein Metalloxidvaristor sein kann,
liegt parallel zu dem Schalter 32.

Im Betrieb wird die Speiseenergie an die Anschlussklemmen 14 und 15 angelegt, wodurch ein
Gleichspannungspotential an die Reihenschaltung aus dem im Ausgangszustand gesperrten
ersten Schalters 16 und der Schützwicklung 10
angelegt wird. Da der erste Schalter 16 unwirksam
ist, fliesst kein Strom und die Kontaktstücke 12
bleiben offen. Unmittelbar nach der Anlegung einer Spannung wird die Stromversorgungseinrichtung 18 in Betrieb gesetzt, die nun eine mit Vc bezeichnete Hilfsspannung erzeugt, um die verschiedenen Bauelemente des Steuerkreises zu betreiben. Zusätzlich wird ein «Stromversorgung-Ein»-Signal, dass im einfachsten Fall aus der Höhe der Spannung abgeleitet wird, an die Abschaltstufe 28 und an den Steuereingang des zweiten Schalters 32 zur Betätigung desselben angelegt.

Es sei erwähnt, dass die als Schalter 16 und 32 dargestellten Elemente durch unterschiedliche Arten von Transistoren, Feldeffekttransistoren und Thyristoren gebildet sein können. Für die Zwecke der vorliegenden Beschreibung werden die Steueranschlüsse solcher Elemente als Steuerelektrode bezeichnet, obwohl im Einzelfall abweichende Bezeichnungen in Betracht kommen.

Wenn die Stromversorgungseinrichtung 18 in Betrieb ist, wird durch die Abschaltstufe 28 kein Signal erzeugt. Auch beim Fliessen normaler Ströme durch die Wicklung 10 werden Signale erzeugt, welche die Abschaltstufe 28 nicht betätigen. Ein Signal der Verzögerungsstufe 36 veranlasst die Referenzsignalstufe 26 ein Signal zu erzeugen, das die Zuführung breiter Steuerimpulse zu dem ersten Schalter 16 gestattet, wenn es an den Schaltungspunkt 22 angelegt wird. Diese Steuerimpulse betätigen den ersten Schalter für einen verhältnismässig langen Teil jeder Signalperiode (Hochlastzyklus), so dass ein verhältnismässig grosser Strom durch die Wicklung 10 fliesst.

Nach einer gewissen Zeit läuft die Verzögerungsstufe 36 ab und gibt ein Ausgangssignal eines zweiten Pegels an die Referenzsignalstufe 26 ab. Diese gibt dann ein Signal an den Summierungspunkt 22 ab, das die Abgabe nur verhältnismässig kurzer Steuerimpulse (Niedriglastzyklus) an die Steuerelektrode des ersten Schalters 16 während jeder Schwingungsperiode gestattet, wie dies in idealisierter Form durch die Kurvenform am rechten Ende des Wellenzuges 21 dargestellt ist. Durch Einstellung der durch die Verzögerungsstufe 36 bereitgestellten Verzögerung derart, dass sie etwas länger als die zum Schliessen der Kontaktstücke 12 benötigten Zeit ist, wird der erste Schalter 16 gezwungen, einen verhältnismässig langdauernden Anzugsstrom für die Wicklung 10 zum Einschalten der Kontaktstücke bereitzustellen, wird jedoch kurz darauf auf ein Zeitverhältnis zurückgeschaltet, in dem ein geringerer Strom bereitgestellt wird, der dem Haltestrom zur Aufrechterhaltung der geschlossenen Stellung der Kontaktstücke entspricht. Da das Schütz im Haltezustand für wesentlich längere Zeiträume als im Anzugszustand verbleibt, braucht die Wicklung 10 nicht so gross und schwer und thermisch derart bemessen zu sein, wie dies der Fall wär, wenn sie den vollen Anzugsstrom während der gesamten Betriebszeit des Schützes führen müsste. Gleichzeitig wird nur die Energie benötigt, die zur Aufrechterhaltung des Haltestromes benötigt wird, da der Strom durch den Betrieb des ersten Schalters 16 mit einem Zeitverhältnis gesteuert wird, anstatt in grossen Vorwiderständen oder anderen unwirtschaftlichen Reihenimpedanzen vernichtet zu werden.

Wie durch eine gestrichelte Linie in Figur 1 angedeutet ist, gibt es andere Verfahren zum Betrieb der Schaltungsanordnung z. B. um diese mittels eines geeigneten Signalwandlers 38 in Abhängigkeit von der erfassten Betätigung der Kontaktstücke 12 zur Abgabe des Steuersignals für den niedrigen Strompegel zu veranlassen. Ein Signalwandler dieser Art kann im einfachsten Fall ein Widerstand sein, der den Strom über die Kontaktstücke, die Spannung an den Kontaktstücken oder das magnetische Feld der Schützwicklung erfasst, da alle diese Grössen als Anzeichen für das Schliessen der Kontaktstücke verwendbar sind. Nach dem Schliessen der Kontaktstücke gibt die Verzögerungsstufe 36 durch die Referenzsignalstufe 26 ein Signal ab, das dem Summierungspunkt 22 zugeleitet wird und dass eine Abnahme des Zeitverhältnisses der Steuerung des ersten Schalters 16 veranlasst, wodurch der durch die Wicklung 10 fliessende Strom verringert wird.

Obwohl es für die Wirkungsweise der vorstehend beschriebenen Schaltungsanordnung nicht erforderlich ist, wird bei einer bevorzugten Ausführungsform ein zweiter elektrischer Schalter 32 in Reihe mit der Wicklung 10 geschaltet und mit der Stromversorgungseinrichtung 18 verbunden. Wenn die Anordnung an Spannung angelegt wird, wird der zweite Schalter 32 betätigt, um einen Strom durch die Wicklung 10, die Diode 40 und den Schalter fliessen zu lassen. Ist der erste Schalter 16 geschlossen und wird ein positives Potential an das obere Ende der Wicklung 10 angelegt, so fliesst ein Strom abwärts durch die Wicklung 10 im Nebenschluss zu dem Teil der Schaltung, der den zweiten Schalter 32 und die Diode 40 enthält. Wird jedoch der Schalter 16 gesperrt, so bewirkt jedoch die plötzliche Wegnahme des Potentials von den Enden der Wicklung 10 kein sofortiges Ende des Stromflusses, da der durch eine Induktivität fliessende Strom nicht plötzlich aufhören kann. Gäbe es keinen Ausweichpfad für den Strom, so würde der induktive Spannungsstoss der Wicklung 10 an dem ersten Schalter 16 eine zerstörend hohe Spannung hervorrufen. Stattdessen fliesst der Strom bei der dargestellten Anordnung durch die Wicklung 10 weiter, jedoch nun unter Bildung eines geschlossenen Stromkreises aufwärts durch die Diode 10 und den zweiten Schalter 32. Auf diese Weise vermag der Strom trotz der augenblicklichen Sperrung des ersten Schalters 16 weiterhin durch die Wicklung 10 zu fliessen.

Soll das Schütz nun zur Trennung der Kontaktstücke abgeschaltet werden, so wird der Stromfluss durch Sperrung des ersten Schalters 16 beendet. Würde der zweite Schalter 32 im eingeschalteten Zustand verbleiben, so würde jedoch der Strom durch die Wicklung 10 für einige Zeit weiterfliessen. Die sich daraus ergebende nur allmähliche Schwächung des Feldes würde zu einer verhältnismässig langsamen Trennung der Kontaktstücke 12 führen. Dies ist schädlich für das Schütz, da eine verlängerte Lichtbogendauer mit Abbrand und Zerstörung des Kontaktmaterials die Folge ist. Stattdessen wird durch die Wegnahme der Spannungsquelle die Stromversorgungseinrichtung 18 abgestellt, die ihrerseits den zweiten Schalter 32 sperrt. Damit an dem zweiten Schalter 32 keine zerstörend hohe Spannung auftritt, verbleibt jedoch in dem Stromkreis eine Impedanz in der Gestalt eines Varistors 42, so dass der induktive Strom der Wicklung 10 durch die Diode 40 und den Varistor 42 fliesst und ohne Schaden für den Stromkreis als Ganzes abgebaut wird. Dies gestattet eine rasche Abnahme des Wicklungsstromes und damit eine ausreichend rasche Trennung der Kontaktstücke 12, ohne dennoch eine zerstörend hohe Spannung in dem induktiven Stromkreis hervorzurufen.

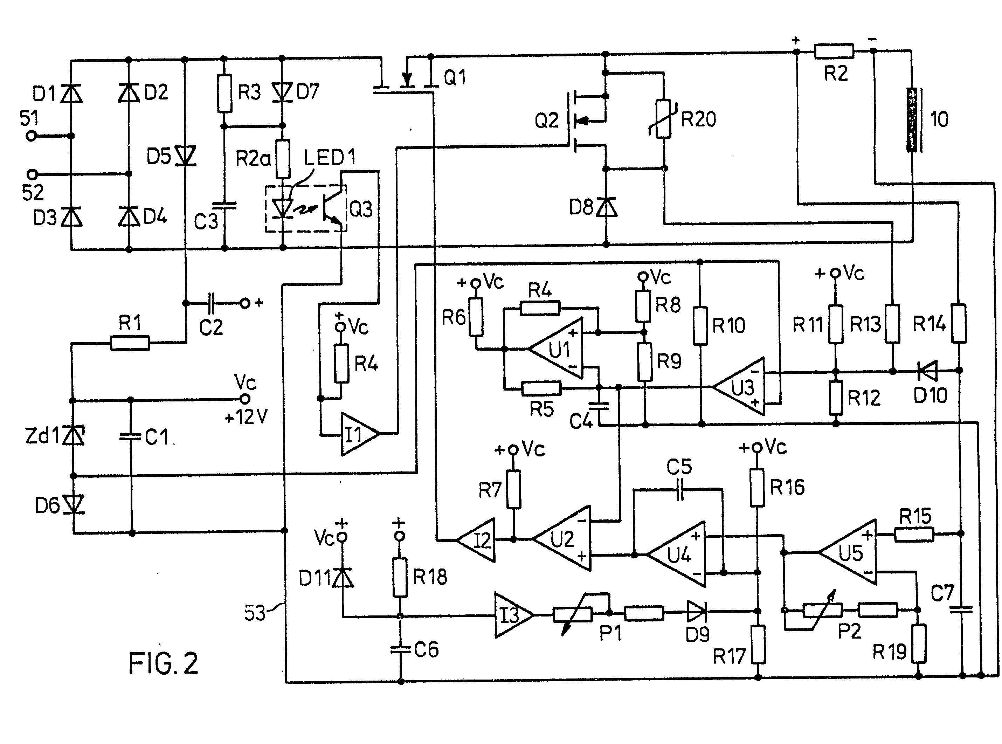

In der Figur 2 ist eine aus üblichen Elementen gebildete Schaltungsanordnung gezeigt, die weitere Ausgestaltungen der Erfindung enthält.

Aus einer an die Anschlusspunkte 51 und 52 angeschlossenen nicht gezeigten Stromquelle, bei der es sich um eine Wechselspannungsquelle handeln kann, wird mittels einer üblichen Brückenschaltung mit Dioden D1 bis D4 eine Gleichstromspannung gewonnen. Eine Stromversorgungseinrichtung zur Bereitstellung einer geregelten kleineren Gleichspannung zum Betrieb weiterer Teile der Schaltung umfasst eine weitere Diode D5 in Reihe mit einem Widerstand R1 sowie eine Zenerdiode Zd1 und eine Diode D6. Die zuletzt genannten beiden Elemente werden durch einen Kondensator C1 überbrückt, um eine relativ geglättete Spannung Vc von etwa 12 Volt bereit zu stellen.

Ein weiterer Kondensator C2 ist zwischen den Verbindungspunkt der Diode D5 und des Widerstandes R1 und das obere Ende der Wicklung 10 geschaltet, um als vorübergehende Stromquelle während der Pausen zwischen den Impulsen der Zeitverhältnissteuerung zu dienen.

Wie man erkennt, sind der Kondensator C1, die Diode D6 und weitere Elemente an eine gemeinsame Leitung 53 angeschlossen, die ihrerseits an das negative oder stromerregende Ende eines Widerstandes R2 angeschlossen sind, der in Reihe mit der Wicklung 10 geschaltet ist. Der Widerstand R2 stellt eine kleine Spannungsquelle als Stromsensor für die Grösse des in der Wicklung fliessenden Stromes dar und ist bei einem Wert von 0,2 Ohm von ausreichend geringer Grösse, um keine wahrnehmbare Energie zu verbrauchen. Das positive Ende des Widerstandes R2 ist mit mehreren Schaltungspunkten verbunden und dient als Spannungsquelle für Betätigungsstufen, die der Unterbrechungsstufe 28 und der Verstärkerstufe 34 in Figur 1 entsprechen.

Eine weitere Spannungsquelle wird durch eine Diode D7 in Reihe mit einem Widerstand R2a und einer Leuchtdiode LED 1 (als Bestandteil eines üblichen Optokopplers Q3) gebildet, die parallel zu der Wicklung in Reihe mit einem Widerstand R3 und einem Kondensator C3 wie dargestellt geschaltet sind. Wie erwähnt, umfasst die Leuchtdiode Led 1 einen integralen Teil eines optisch gesteuerten Transistors, der zwischen das Steuergitter eines Feldeffekttransistors Q2 und die Sammelleitung 53 geschaltet ist. Ein Widerstand R4 und ein invertierender Puffer (buffer) I1 sind zwischen den Kollektor des Optokopplers Q3 und die Steuerelektrode des Feldeffekttransistors Q2 geschaltet. Der Puffer I1 und weitere im folgenden erwähnte Puffer sind vorzugsweise CMOS-Elemente mit hohem Eingangswiderstand, die mit einer Betriebsspannung von 12 Volt betrieben werden.

Um die geforderte zeitabhängige Ausgangsgrösse des Stromes zu erzielen, ist ein Oszillator vorgesehen, der einen Komparator U1 und Rückkopplungswiderstände R4, R5 umfasst, die an den positiven und negativen Eingang angeschlossen sind sowie einen Widerstand R6, der zwischen den Ausgang und eine geregelte Quelle einer Hilfsspannung Vc angeschlossen ist. Der Oszillator ist seinerseits mit dem negativen Eingang eines Komparators U2 verbunden, dessen Ausgang über den Widerstand R7 und mit an die Hilfsspannung Vc angelegt ist dem Steueranschluss eines weiteren Feldeffekttransistors Q1 mittels eines invertierenden Puffers I2 angeschlossen ist. Der Transistor Q1 entspricht dem ersten Schalter 16 in Figur 1. Dem Komparator U1 wird mittels eines aus Widerständen R8 und R9 gebildeten Spannungsteilers ein positives Potential zugeführt. Ein weiterer Widerstand R10 dient als Nebenschluss zu der Diode D6, um einen Strom an der Diode vorbeizuleiten. Während der Komparator U1 mit fester Ausgangsfrequenz geschaltet ist, kann eine Spannungsrückkopplung vorgesehen sein, um einen spannungsgesteuerten Oszillator zu schaffen.

Ein Überwachungskomparator U3 ist mit seinem positiven Eingang an die Anode einer Diode D6 angeschlossen, um das Vorhandensein der Hilfsspannung Vc zu überwachen. Der negative Eingang des Komparators U3 ist mit einem Spannungsteiler verbunden, der aus Widerständen R11 und R12 gebildet ist, die zwischen der Hilfsspannung Vc und der Referenzleitung liegen. Der negative Eingang des Überwachungskomparators U3 ist ferner mittels der Widerstände R13 und R14 an den Freilaufkreis zur Wicklung 10 und die positive Seite des Widerstandes R2 angeschlossen. Der Spannungsabfall an dem Feldeffekttransistor Q2 wird mittels eines Widerstandes R13 überwacht, während ein Überstrom in der Wicklung 10 mittels des Widerstandes R14 und der Diode D10 erfasst wird. Wie man erkennt, wird die Freilaufschleife zur Wicklung 10 aus einer Reihenkombination einer Freilaufdiode D8 und dem Feldeffekttransistor Q2 gebildet, parallel zu dem ein Metalloxidvaristor R20 liegt.

Ein verstärktes Fehlerstromsignal wird dem positiven Eingang des Komparators U2 durch den Operationsverstärker U4 zugeführt, parallel zu dem ein Rückkopplungskondensator C5 liegt und an dessen negativen Anschluss eine Eingangsgrösse anliegt, die von einem aus den Widerständen R16 und R17 gebildeten Spannungsteiler abgeleitet ist. Eine weitere Eingangsgrösse des negativen Anschlusses wird von dem Ausgang des invertierenden Puffers I3 abgeleitet, dessen Aus-

gangsspannung durch ein Potentiometer P1 und einen Widerstand R17 gesteuert wird und der an den negativen Anschluss mittels einer Trenndiode D9 verbunden ist. Am Eingang des Puffers I3 liegt ein Widerstand R18 in Verbindung mit einem Kondensator C6, und eine Begrenzerdiode D11 gestattet eine rasche Entladung des Kondensators C6, wenn die Stromversorgung abgeschaltet wird.

Der andere positive Eingang des Operationsverstärkers U4 empfängt die Ausgangsgrösse eines zweiten Operationsverstärkers U5, dessen positive Eingangsgrösse von dem Spannungsabfall an einem Widerstand R2 über Widerstände R14 und R15 abgeleitet wird. Ein Kondensator C7 dient zur Filterung von Störspannungen an dem positiven Eingang des Operationsverstärkers U5. An dem negativen Eingang liegt eine Rückkopplungsspannung über ein Potentiometer P2 an und ist mit der Referenzleitung 53 durch einen Widerstand R19 verbunden.

Die beschriebene Ausführungsform der Erfindung lässt sich mit handelsüblichen Bauelementen aufbauen. Die Komparatoren sind vorzugsweise ein Typ mit einer einzigen Versorgungsspannung mit der handelsüblichen Typenbezeichnung LM 339.

Bei einer erfolgreich geprüften Ausführungsform der Erfindung waren die Verstärker Operationsverstärker des Typs LM 324 mit einheitlicher Versorgungsspannung. Es ist jedoch darauf hinzuweisen, dass die Erfindung auch ohne weiteres mit anderen geeigneten Bauelementen verwirklicht werden kann.

Im Betrieb wird eine Wechselspannung an die Klemmen 51 und 52 angelegt und es erscheint eine gleichgerichtete Spannung an der Reihenschaltung des Schalters Q1, des Widerstandes R2 und der Wicklung 10. Die positive Spannung erzeugt einen Strom durch die Diode D5, den Widerstand R1, die Zenerdiode Zd1 und die Diode D6, wobei von dem Spannungsabfall an Q1 und R2 Gebrauch gemacht wird. Beginnt Strom zu fliessen, so erscheint an der Diode D6 eine Spannung, die den Oszillator mit dem Komparator U1 betätigt. An dem oberen oder negativen Eingang des Komparator U2 erscheint dann eine Dreieckspannung, die den Schaltzustand sich von U2 verändert. Unter dem Einfluss der Hilfsspannung Vc wird das Potential des Puffers I2 durch den Widerstand R7 hochgezogen, und der Speicher erzeugt eine ins Negative gehende Spannung an der Steuerelektrode des Schalters Q1, der hierdurch im Sperrzustand gehalten wird. Nimmt jedoch die negative Eingangsgrösse des Komparators U2 über den Wert der an den negativen Eingang angelegten Referenzspannung zu, ändert der Komparator seinen Schaltzustand, um ein negatives Potential an dem Puffer I2 anzulegen, wodurch eine positiv werdende Spannung durch den Puffer an die Steuerelektrode von Q1 angelegt wird, und dieser dadurch einen Strom führen kann. Die von dem Oszillator erzeugte Dreieckspannung nimmt daraufhin ab, was schliesslich dazu führt, dass der Komparator U2 in den H-Zustand zurückkehrt und

der Puffer I2 wiederum den L-Zustand annimmt und dadurch den Schalter Q1 sperrt.

Diese Vorgänge sind in der Figur 2a dargestellt, in der die Dreieckspannung Vd den Oszillatorausgang darstellt, der an dem negativen Eingang des Komparators U2 erscheint, und eine Referenzspannung Vr mit veränderlichen Pegel stellt die Spannung dar, die an den positiven Eingang von U2 angelegt wird.

Wenn die Dreieckspannung die Referenzspannung übersteigt, nimmt der Ausgang des Komparators U2 den H-Zustand an, wie dies durch die Kurve U9 angegeben ist. Während die Referenzspannung Vr ansteigt, nimmt die Dauer des H-Ausganges von U2 ab. Da die Signalperiode konstant ist, nimmt das Verhältnis der Einschaltzeit zu der Ausschaltzeit des Schalters Q1, d.h. sein Belastungsgrad in dem Mass ab, wie die Vergleichsspannung Vr ansteigt.

Wie man nun erkennt, hängt die relative Einschaltdauer des Transistors Q1 von den relativen Pegeln der an den negativen Eingang des Komparators U2 angelegten Dreieckspannung ab, und zwar im Vergleich zu der Referenzspannung, die an den positiven Eingang angelegt wird. Um eine verhältnismässig lange Einschaltzeit des Schalters Q1 zu erreichen, ist es zunächst erwünscht, dass die an U2 angelegte Referenzspannung verhältnismässig niedrig ist. Um dies zu erreichen, ist ein Zeitkreis mit einem Widerstand R18 und einem Kondensator C6 parallel zu dem Eingang des Speicherschalters I3 geschaltet. So bald die Stromversorgung eingeschaltet wird, erscheint die Hilfsspannung Vc an dem oberen Ende des Widerstandes R18 und beginnt den Kondensator C6 zu laden. Während der Kondensator aufgeladen wird, ist der Eingang des Puffers I3 im L-Zustand, so dass der Ausgang des Schalters auf verhältnismässig hohem positiven Potential liegt, das durch einen Spannungsteiler aus dem Potentiometer P1 und dem Widerstand R17 gebildet ist. Die an dem oberen Ende des Widerstandes R17 erscheinende Spannung ist dann verhältnismässig hoch und wird an den negativen Eingang des Verstärkers U4 angelegt, um eine verhältnismässig niedrige Ausgangsspannung zu erzeugen. Diese niedrige Spannung, die als Referenzspannung an dem positiven Anschluss des Komparators U2 liegt, gestattet eine Triggerung des Komparators U2 zu einem verhältnismässig frühen Zeitpunkt im Verlauf entlang einer Flanke der von dem Oszillator ausgegebenen Dreieckspannung. Dann wird U2 zu einem relativ frühen Zeitpunkt in der Wellenperiode Ein-getriggert und zu einem verhältnismässig späten Zeitpunkt in der Periode Aus-getriggert, so dass die Einschaltdauer von U2 für jede Oszillatorperiode verhältnismässig lang ist. Dies bewirkt einen ausgeprägten Hochlastzyklus des Transistors Q1, der seinerseits einen verhältnismässig hohen Strom durch die Wicklung 10 fliessen lässt. Durch passende Einstellung des Potentiometers D1 und anderer Elemente der Schaltung lässt sich ein ausreichender Strom für die Anzugsphase erreichen, d.h. die Wicklung 10 wird zum Schliessen der Kontaktstücke in geeigneter Weise veranlasst.

Nach dem eine gewisse, durch die relativen Werte des Widerstandes R18 und des Kondensators C6 bestimmte Zeit verstrichen ist, lädt sich der Kondensator ausreichend auf, um den Puffer I3 zur Änderung seines Zustandes zu veranlassen (in diesen Fall, um in den Zustand niedriger Spannung überzugehen). Die Trenndiode D9 verhindert, dass diese niedrige Spannung dem Verstärker U4 zugeführt wird und trennt den negativen Eingang von I3, so dass nur die von dem aus den Widerständen R16 zu R17 gebildeten Spannungsteiler abgeleiteten Spannung angelegt wird. Diese Spannung ist nicht so niedrig wie die von dem Puffer I3 abgegebene Spannung, ist jedoch beträchtlich niedriger als die von I3 in seinen H-Zustand abgegebene Spannung. Aufgrund der höheren Bezugsspannung, die nun an dem positiven Eingang des Komparators U2 erscheint, wird dieser seinen Zustand solange nicht ändern, bis die Sägezahnspannung an seinem negativen Eingang einen höheren Pegel als zuvor erreicht hat. Mit anderen Worten, der Komparator wird seinen Zustand im Verlauf der Periode der Dreieckspannung erst später ändern und wird in diesem Zustand nur für einen kürzeren Zeitraum verbleiben, aufgrund der kürzeren Zeit während der die Dreieckspannung Vd die Referenzspannung Vr überschreitet (Figur 2a). Dies führt zu einer wesentlich kürzeren Dauer der Einschaltimpulse an der Steuerelektrode des Transistor Q1, so dass dieser nur für einen kürzeren Teil des Oszillatorszyklus eingeschaltet ist und durch die Wicklung 10 ein entsprechend kleinerer Strom geleitet wird.

Der Verstärker U4 erzeugt ein Ausgangssignal, das nach einer anfänglichen Verzögerungszeit ein Fehlersignal darstellt, das die Differenz zwischen dem Referenzsignal des Spannungsteilers R16, R17 und einem verstärkten Stromsignal des Verstärkers U5 darstellt. Der Ausgang von U5, dessen Pegel mittels des Potentiometers P2 einstellbar ist, stellt eine Stromrückführung dar, die das von U4 abgegebene Fehlersignal steuert, um vorbestimmte Pegel des Stroms sowohl beim Anziehen als auch im Haltezustand aufrechtzuerhalten.

Wie man erkennt, bewirkt die Reihenschaltung des Widerstandes 18 und des Kondensators C6 in Verbindung mit dem Speicher I3 eine Verzögerungsfunktion, die eine erste Referenzspannung zur Erzielung eines Hochlastzyklus bewirkt und im folgenden eine niedrigere Referenzspannung zur Erzielung eines Schwachlastzyklus, so dass nach einer angemessenen Anzugsperiode, die durch R18 und C6 bestimmt ist, der Strom auf einen niedrigen Pegel zurückkehrt, der zur Aufrechterhaltung des Schützes in seiner geschlossenen Stellung ausreicht.

Wird die Energieversorgung der Wicklung unterbrochen, ist eine sofortige Sperrung des Transistors Q1 erwünscht, um die Wicklung abzuschalten, und ferner ist es erwünscht, dass die sofortige Abschaltung des Transistors Q2 sichergestellt ist. Um dies zu erreichen, wird die Betätigungsspannung des Transistors Q3 aus einem parallel zu der Gleichrichterbrücke gelegten Kreis abgeleitet. Liegt Spannung an der Brückenschaltung an, so wird der Ausgangstransistor Q3 betätigt, der den Eingang des Puffers I1 herabzieht, wodurch ein H-Potential an die Steuerelektrode des Transistors Q2 angelegt wird. Fällt die Energie aus, so wird der Transistor Q3 nichtleitend und der Eingang des Puffers I1 wird durch den Widerstand R4 hochgezogen, was den Ausgang des Transistors verringert und den Transistor Q2 sperrt. Hierdurch wird der Varistor R20 in Reihe mit der Wicklung 10 gelegt.

Gleichzeitig erzeugt der Verlust der Eingangsspannung eine relativ niedrige Vorspannung an dem positiven Eingang des Überwachungskomparators U3. Dies veranlasst U3, eine verhältnismässig niedrige Spannung abzugeben, die die Ausgangsgrösse des Oszillators unwirksam macht, was den Komparator U2 zur Abgabe einer positiv werdenden Kurvenform veranlasst, die ihrerseits die Sperrung des Transistors Q1 veranlasst und auf diese Weise die Wicklung 10 von der Gleichrichterstufe trennt.

Der Überwachungskomparator U3 spricht auch auf Situationen an, in denen der über die Wicklung 10 fliessende Strom einen erwünschten Maximalwert überschreitet. Fliesst ein überhöter Strom durch die Wicklung, so entsteht an den Widerstand R2 ein positiver Spannungsabfall, der über die Diode D10 dem negativen Eingang des Komparators U3 mitgeteilt wird. In ähnlicher Weise wird an den selben Punkt eine verhältnismässig hohe Spannung angelegt, falls der Schalter Q2 gesperrt wird. Dies veranlasst den Komparator U3, einen nierigeren Ausgangspegel anzunehmen, der den Schalter Q1 über den Komparator U2 in den Sperrzustand bringt.

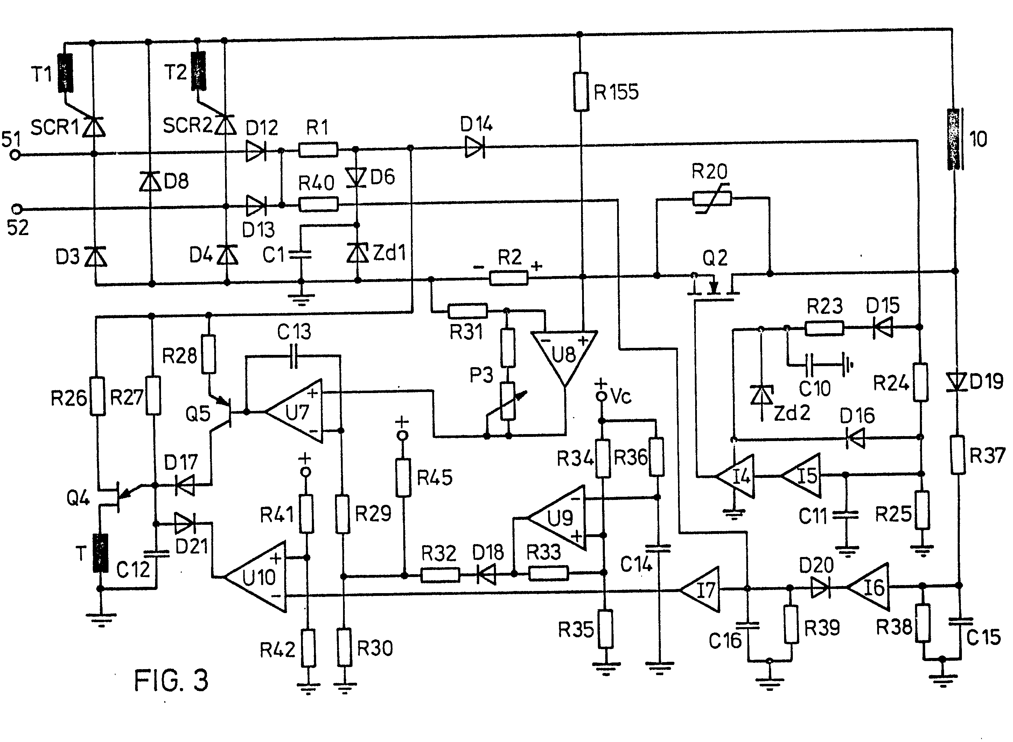

Im folgenden wird die Figur 3 betrachtet, in der ein weiteres Ausführungsbeispiel der Erfindung dargestellt ist, in welchem eine Thyristorbrückenschaltung anstelle eines einzigen in Reihe mit der Wicklung geschalteten Schalters vorgesehen ist. Wie zuvor, kann eine Wechselstromversorgung an die Klemmen 51 und 52 angelegt werden und eine Brückenschaltung wird zur Gleichrichtung des Stromes benutzt, um die Wicklung 10 mit Gleichstrom zu versorgen. Die Dioden D1 und D2 des Ausführungsbeispieles gemäss der Figur 2 sind durch Thyristoren SCR 1 und SCR 2 ersetzt, deren Steuerelektroden mittels der Sekundärwicklungen T1 und T2 eines Transformators T mit Steuersignalen gespeist werden. Die Stromversorgung zur Betätigung des Steuerkreises umfasst Dioden D12 und D13, die parallel zu der Wicklung 10 mittels eines Widerstandes R1, einer Diode D6 und einer Zenerdiode Zd1 geschaltet sind. Parallel zu der Zenerdiode Zd1 ist ein Filter- oder Verzögerungskondensator C1 eingeschaltet entsprechend der Schaltung gemäss der Figur 2. Die Diode D8 ist eine Freilaufdiode entsprechend der Schaltung der Figur 2. Ein Schalter zur Schliessung des Freilaufkreises der Wicklung 10 wird durch den Transistor Q2 und den parallelliegenden Varistor R20 gebildet. Ein parallel zu der Gleichrichterbrücke liegender Widerstand R155 stellt sicher,

dass zu jeder Zeit ein Haltestromkreis für die Thyristoren besteht. Ein in Reihe mit der Wicklung 10 liegender Widerstand R2 sorgt für eine geringe Spannung als Rückkopplungssignal für den Steuerstromkreis. Die durch die Stromversorgungseinrichtung bereitgestellte positive Vorspannung wird durch die Diode D14 an einen ersten RC-Kreis angelegt, der aus Widerständen R24, R25 und einem Kondensator C11 gebildet ist. Die Diode D15 verbindet den Stromkreis durch den Widerstand R23 mit einem Kondensator C10. Die parallel zu dem Kondensator C10 geschaltete Zenerdiode Zd2 stellt eine stabilisierte Spannungsversorgung für alle Puffer dar, während die Diode D16 zur Begrenzung der an dem Kondensator C11 auftretenden Spannung dient, obwohl zur Vereinfachung der Darstellung die Zenerdiode Zd2 als nur mit dem Puffer I4 verbunden dargestellt ist.

Die Stromversorgungseinrichtung ist ferner mit einem Oszillatorkreis verbunden, der aus einem geeigneten Schalter gebildet ist, bei dem es sich hier um einen Unijunctiontransistor Q4 handelt, dessen Basis-1/Basis-2-Kreis in Reihe zwischen dem Widerstand R26 und der Primärwicklung des Transformators T liegt. Der Emitter des Transistors Q4 ist an die Verbindung des Zeitwiderstandes R27 und des Kondensators C12 angeschlossen. Parallel zu dem Widerstand R27 liegt eine Reihenschaltung aus einem kleineren Widerstand R28, einem Transistor Q5 und einer Diode D17. An den Verstärker U7 ist ein Rückkopplungskondensator C13 angeschlossen und sein Ausgang ist an die Basis des Transistors Q5 angeschlossen. Der negative Eingang des Verstärkers U7 ist mit einem Referenzpotential verbunden, und zwar über Widerstände R29 und R30 mit Erdpotential.

Der positive Eingang des Verstärkers U7 ist mit dem Ausgang eines weiteren Komparators U8 verbunden. Ein Rückkopplungspotentiometer P3 und ein Widerstand R31 legen den Verstärker U8 an den Widerstand R2.

Eine Verzögerungseinheit mit einem Verstärker U9 ist mittels einer Diode D18 und eines Widerstandes R32 an den negativen Eingang des Verstärkers U7 angeschlossen. Eine Rückkopplungsschleife zum positiven Anschluss wird mittels eines Widerstandes R33 gebildet, und der positive Anschluss ist an eine Hilfsspannung Vc über einen weiteren Widerstand R34 angelegt. Die Widerstände R34 und R35 bilden einen Spannungsteiler, um positives Potential an den positiven Anschluss von U9 anzulegen. Dieses Potential wird durch Rückkopplung durch den Widerstand R33 beeinflusst. Ein R-C-Kreis aus einer Reihenschaltung eines Widerstandes R36 und eines Kondensators C14 ist mit seinem Verbindungspunkt an den negativen Anschluss des Verstärkers U9 angeschlossen.

In dem vorstehend beschriebenen Ausführungsbeispiel enthält die Unterbrechungsschaltung die Kombination einer Diode D19 und eines Widerstandes R37, parallel zu denen eine Filterkombination aus dem Widerstand R38 und dem Kondensator C15 liegen. Das Signal wird an den Eingang eines Puffers I6 angelegt. Eine Begrenzerdiode D20, parallel zu der nach Erde eine weitere Filterkombination aus einem Widerstand R39 und einem Kondensator C16 geschaltet ist, liegt über einen Widerstand R40 an der Stromversorgung und ist mit dem Eingang eines weiteren Puffers I7 verbunden. Die Ausgangsgrösse des Puffers I7 gelangt zu dem negativen Eingang des Komparators U10, dessen positiver Anschluss mit dem Verbindungspunkt eines aus den Widerständen R41 und R42 gebildeten Spannungsteilers verbunden ist, während der Ausgang des Komparators U10 an dem Emitter des Transistors Q4 durch eine Trenndiode D21 verbunden ist.

Wenn die Stromversorgung eingeschaltet wird, sind die Thyristoren SCR 1 und SCR 2 gesperrt, da an ihren Steuerelektroden keine Signale anliegen. In Abhängigkeit davon, ob der Anschluss 51 oder 52 positiv ist, leitet die Diode D12 oder Diode D13, was einen Spannungsabfall an dem Widerstand R1 und den Dioden D6 und Zd1 hervorruft. Das an dem Verbindungspunkt des Widerstandes R1 und der Diode D6 entstehende Potential lädt den Kondensator C12 über den Zeitwiderstand R27 auf. Wenn der Kondensator C12 eine ausreichende Spannung erreicht hat, wird der Transistor Q4 leitend, und der Kondensator C12 wird durch die Primärwicklungen T1 und T2 des Transformators T entladen. Der in den Sekundärwicklungen T1 und T2 des Transformators T auf diese Weise induzierte Impuls dient zur gleichzeitigen Zündung der Thyristoren SCR 1 und SCR 2. Wie man erkennt, ist einer der Thyristoren stets in Durchlassrichtung vorgespannt, während der andere stets in Sperrrichtung vorgespannt ist, so dass nur einer der beiden Thyristoren jeweils leitend ist. Der leitende Thyristor speist Strom zum oberen Ende der Wicklung 10, so dass diese von einem Gleichstrom durchschlossen wird.

Zur gleichen Zeit wird das zwischen dem Widerstand R1 und der Diode D6 entstehende Potential Vc mittels der Diode D14 den Puffern I4 und I5 mitgeteilt. Nachdem zuerst der Transistor Q2 durch den Puffer I4 betätigt 30 wurde, werden nun die Thyristoren SCR 1 oder 2 leitend geschaltet. Nun fliesst Strom durch den Stromkreis und den Widerstand R2, wodurch an den Verstärker U8 eine Spannung angelegt wird, was zu einem Eingangssignal an dem positiven Eingang des Verstärkers U7 führt. Eine relativ niedrige Spannung erscheint an dem negativen Eingang des Verstärkers U7, die von dem Widerstandsteiler R45 und R30 stammt, so dass der Verstärker U7 eine relativ hohe Ausgangsspannung erzeugt, die den Transistor Q5 in den Sperrzustand vorspannt.

Aufgrund der anfänglichen Einschaltung der Energieversorgung fliesst Strom durch den Zeitkreis aus dem Widerstand R36 und dem Kondensator C14 des Verzögerungsverstärkers U9. An dessen positivem Anschluss erscheint anfänglich eine relativ hohe Spannung, während an dem negativen Anschluss eine niedrige Spannung erscheint, mit dem Ergebnis, dass an dem negativen Anschluss des Verstärkers U7 eine verhältnismässig hohe Spannung angelegt wird, welche die niedrigere Hilfsspannung Vc überwindet. Auf diese Weise wird eine vorübergehende Vorspannung bereitgestellt, die den Nebenschlusstransistor Q5 in Durchgangsrichtung vorspannt, und der Zeitkondensator C12 wird durch einen relativ niedrigen Widerstand R28 rasch aufgeladen, um in jeder Halbwelle eine möglichst frühe Durchschaltung der Thyristoren SCR 1 und SCR 2 zu erreichen.

Nachdem ein gewisser, durch die relativen Werte des Widerstandes R36 und des Kondensators C14 bestimmter Zeitraum verstrichen ist, lädt sich der Kondensator auf einen Wert auf, bei dem eine ausreichende Spannung an den negativen Eingang des Verstärkers U7 angelegt wird und dieser hierdurch in den L-Zustand geschaltet wird. Die Trenndiode D18 wird dann in Sperrichtung vorgespannt, so dass die negative Eingangsspannung des Verstärkers U7 ausschliesslich durch das Widerstandsverhältnis der Widerstände R45 und R30 sowie durch die Hilfsspannung Vc bestimmt ist. Diese geringere Spannung veranlasst den Verstärker U7, den Ladestrom des Kondensators C12 durch Anlegen eines grösseren Ausgangssignals an den Transistor Q5 zu regeln. Die Zeitkonstante des Oszillatorkreises ist dann durch den Kondensator C12 in Verbindung mit den Widerständen R27 und R28, die Diode D7 und die gesteuerte Stromleitung des Transistors Q5 bestimmt, was zu einem wesentlich höheren Wert als dem des Widerstandes R28 allein führt. Der Kondensator C12 lädt sich nun langsamer auf und erreicht die für Q4 benötigte Durchbruchspannung zu einem viel späteren Zeitpunkt innerhalb der leitenden Halbwelle als zuvor. Die Thyristoren SCR 1 und SCR 2 werden innerhalb der Halbwelle relativ spät leitend geschaltet und bleiben auch nur für einen kürzeren Zeitraum leitend, so dass der durch die Wicklung 10 fliessende Strom wesentlich geringer ist als zuvor, jedoch ausreichend zur Aufrechterhaltung der geschlossenen Stellung des Schützes.

Die erwünschte Ausschaltfunktion wird durch Anlegen der Spannung der Stromversorgungseinrichtung über den Widerstand R40 an das obere Ende des aus dem Kondensator C16 und dem Widerstand R39 gebildeten Filters erreicht. Fliesst Strom durch den Wicklungsstromkreis, so ist die Diode D20 in Durchlassrichtung vorgespannt, wodurch die von dem Puffer I6 abgegebenen Signale unwirksam gemacht werden. Der Puffer I7 wird zur Abgabe seines L-Zustandes an den negativen Eingang des Verstärkers U10 angeregt, wodurch das von diesem abgegebene positive Signal die Diode D21 in Sperrichtung vorspannt und hierdurch den Verstärker U10 von dem Ladekreis des Oszillators trennt.

Wird die Stromversorgung abgeschaltet, veranlasst die geringere Spannung am Eingang des Puffer I7 diesen in den H-Zustand überzugehen mit dem Ergebnis, dass der Verstärker U10 zur Abgabe einer negativen Spannung veranlasst wird, was den Kondensator C12 rasch entlädt. Auf diese Weise wird der Oszillator in Abhängigkeit von der Unterbrechung der Spannung der Stromversorgungseinrichtung rasch gesperrt.

In ähnlicher Weise wird die Diode D19 in Durchlassrichtung vorgespannt und der Speicher I6 wird nach einer kurzen Verzögerungszeit zur Abgabe eines L-Signals veranlasst, falls der Transistor Q2 wie bei einer Unterbrechung der Energieversorgung der Wicklung abgeschaltet wird, und die niedrigere Spannung wird über die nun in Durchlassrichtung vorgespannte Diode D20 geleitet, was den Puffer I7 zur Annahme eines H-Zustandes veranlasst, so dass der Kondensator C12 sofort entladen wird. Mittels des den Kondensator C15 und den Widerstand R38 enthaltenden Zeitkreises wird der Ein-Zustand der Thyristoren SCR 1 und SCR 2 für wenigstens 300 ms aufrechterhalten, auch dann, wenn die Speiseenergie an die Klemmen wieder angelegt wird.

Wie die vorstehende Beschreibung zeigt, sind bestimmte Merkmale der Erfindung nicht auf bestimmte Einzelheiten der dargestellten Beispiele beschränkt, so dass ein Fachmann weitere Abwandlungen oder Anwendungen in Betracht ziehen kann.

Gewerbliche Verwertbarkeit

Die Erfindung ist für Elektromagnete aller Art geeignet, die bei günstiger Bemessung energiesparend betrieben werden sollen. Hierzu gehören insbesondere die Antriebsmagnete von Schaltgeräten, wie Schütze, Relais und dergleichen.

**Patentansprüche**

1. Schaltungsanordnung zur Speisung der Wicklung (10) eines Elektromagneten mit einem Anzugsstrom und einem nachfolgenden Haltestrom, wobei der Speisestromkreis der Wicklung (10) einen steuerbaren elektronischen Schalter (16) mit einer Steuerelektrode enthält, der durch eine Steuereinrichtung (20) periodische Steuerimpulse von veränderbarer Dauer und/oder Frequenz zuführbar sind, dadurch gekennzeichnet, dass der Speisestromkreis einen Stromsensor (30) enthält und dass die Ausgangsgrösse des Stromsensors (30) mittels eines Einstellgliedes (34) der Steuereinrichtung (20) zuführbar ist (Figur 1).

2. Schaltungsanordnung nach Anspruch 1, dadurch gekennzeichnet, dass die Ausgangsgrösse des Stromsensors (30) einer auf einen Grenzwert ansprechenden Abschalteinrichtung (28) zuführbar ist, welche bei Überschreitung des Grenzwertes die Unterdrückung der Steuerimpulse für den ersten elektronischen Schalter (16) veranlasst.

3. Schaltungsanordnung nach Anspruch 1, dadurch gekennzeichnet, dass die Steuereinrichtung einen mit konstanter Frequenz arbeitenden Oszillator (U1, R4, R5, R6) zur Erzeugung einer Dreieckspannung (Vd) und eine Referenzsignalstufe (U4, U5) sowie zur Auswertung der Dreieckspannung (Vd) und eines Referenzsignals eine Vergleichsschaltung (U2) enthält, die periodische Rechteckimpulse variabler Dauer als Steuerimpulse für den ersten elektronischen Schalter (Q1) erzeugt (Figur 2).

4. Schaltungsanordnung nach Anspruch 3, dadurch gekennzeichnet, dass die Steuereinrichtung eine auf die Referenzsignalstufe wirkende Verzögerungsschaltung (R18, C6) zur Bewirkung des Überganges vom Anzugstrom auf den Haltestrom der Wicklung (10) enthält (Figur 2).

5. Schaltungsanordnung nach Anspruch 1, dadurch gekennzeichnet, dass die Steuereinrichtung einen freilaufenden spannungsgesteuerten Oszillator und einen R–C-Zeitkreis zur Anlegung einer zeitveränderlichen Spannung an den Oszillator enthält, um Steuerimpulse entsprechend einem Anzugsstrom und einen Haltestrom zu gewinnen.

6. Schaltungsanordnung nach Anspruch 1, dadurch gekennzeichnet, dass in Reihe mit einem weiteren parallel zu der Wicklung (10) liegenden elektronischen Schalter (32) ein weiterer Stromsensor (33) geschaltet ist, dessen Ausgangsgrösse der Abschalteinrichtung (28) zuführbar ist (Figur 1).

7. Schaltungsanordnung nach Anspruch 1, dadurch gekennzeichnet, dass parallel zu der Wicklung (10) in Reihe mit einer Freilaufdiode (40) ein spannungsabhängiger Widerstand (42) geschaltet ist.

## Claims

1. A circuit arrangement for supplying the winding (10) of an electromagnet with a starting current and a subsequent holding current, wherein the current supply circuit of the winding (10) includes a controllable electronic switch (16) with a control electrode to which periodic control pulses of variable duration and/or frequency can be supplied through a control device, characterised in that the current supply circuit includes a current sensor (30) and in that the output of the current sensor (30) can be supplied to the control device (20) by means of an adjusting member (34) (Fig. 1).

2. A circuit arrangement according to claim 1, characterised in that the output of the current sensor (30) can be supplied to a cut-off device (28) that responds to a limiting value and causes the control pulse for the first electronic switch to be suppressed when the limiting value is exceeded.

3. A circuit arrangement according to claim 1, characterised in that the control device includes an oscillator (U1, R4, R5, R6) operating at constant frequency for providing a triangular voltage (Vd) and a reference signal stage (U4, U5), and a comparison circuit (U2) for generating the triangular voltage (Vd) and a reference signal that produces periodic square-wave pulses of variable duration as control pulses for the first electronic switch (Q1) (Fig. 2).

4. A circuit arrangement according to claim 3, characterised in that the control device includes a delay circuit (R18, C6) acting on the reference signal stage to effect the transition from the starting current to the holding current of the winding (10) (Fig. 2).

5. A circuit arrangement according to claim 1, characterised in that the control device includes a free-wheeling voltage-controlled oscillator and an RC timing circuit for applying a time-variable voltage to the oscillator in order to obtain control pulses corresponding to a starting current and a holding current.

6. A circuit arrangement according to claim 1, characterised in that a further current sensor (33), the output of which can be supplied to the cut-off device (28), is connected in series with a further electronic switch (32) connected in parallel to the winding (10).

7. A circuit arrangement according to claim 1, characterised in that a voltage-dependent resistor (42) is connected in parallel to the winding (10) and in series with a free-wheeling diode (40).

## Revendications

1. Montage pour l'alimentation de l'enroulement (10) d'un électro-aimant avec un courant d'attraction suivi d'un courant de collage, du type dans lequel le circuit du courant d'alimentation de l'enroulement (10) comporte au moins un interrupteur électrique commandable (16) à électrode de commande à laquelle sont susceptibles d'être appliquées, par l'intermédiaire d'un dispositif de commande (20), des impulsions périodiques de commande de durée et /ou de fréquence susceptible d'être modifiée, caractérisé par le fait que le circuit de courant d'alimentation comporte un capteur de courant (30) et que la grandeur de sortie du capteur de courant (30) est susceptible d'être amenée au dispositif de commande (20), par l'intermédiaire d'un organe de réglage (34), (Figure 1).

2. Montage selon la revendication 1, caractérisé par le fait que la grandeur de sortie du capteur de courant (30) est susceptible d'être appliquée à un dispositif de débranchement (28) qui, lors du déplacement de la valeur limite, provoque la suppression des impulsions de commande pour un premier interrupteur électronique (16).

3. Montage selon la revendication 1, caractérisé par le fait que le dispositif de commande comporte un oscillateur (U1, R4, R5, R6) opérant à fréquence constante et à produire une tension triangulaire (Vd), et un étage de signaux de référence (U4, U5), de même qu'un circuit comparateur (U2) pour l'évaluation de la tension triangulaire (Vd) et d'un signal de référence, et qui produit des impulsions périodiques rectangulaires de durée variable, en tant qu'impulsions de commande pour ledit premier interrupteur électronique (Q1), (Figure 2).

4. Montage selon la revendication 3, caractérisé par le fait que le dispositif de commande comporte un circuit à retard (R18, C6) agissant sur l'étage de signaux de référence, en vue de déclencher le passage du courant d'attraction au courant de collage de l'enroulement (10), (Figure 2).

5. Montage selon la revendication 1, caractérisé par le fait que le dispositif de commande comporte un oscillateur de roue libre à commande par la tension et un circuit de temporisation RC, en vue d'appliquer à l'oscillateur une tension variable dans le temps et d'obtenir des impulsions de commande qui correspondent à un courant d'attraction et à un courant de collage.

6. Montage selon la revendication 1, caractérisé par le fait qu'en série avec un second interrupteur électronique (32) monté en parallèle avec l'enroulement (10), est branché un second capteur de courant (33) dont la grandeur de sortie est susceptible d'être appliquée au dispositif de débranchement (28), (Figure 1).

7. Montage selon la revendication 1, caractérisé par le fait qu'en parallèle sur l'enroulement (10) et en série avec une diode de roue libre (40), est montée une résistance non-linéaire (42).

FIG. 1

FIG. 2a

FIG. 2

EP 0 136 968 B1

FIG. 3

EP 0 136 968 B1